Europäisches Patentamt

European Patent Office

Office européen des brevets

(19)

(11) Publication number: **0 291 156 B1**

(12)

# EUROPEAN PATENT SPECIFICATION

(45) Date of publication of patent specification: **16.09.92**  (51) Int. Cl.⁵: **H02H 3/17**

(21) Application number: **88302668.4**

(22) Date of filing: **25.03.88**

(54) **Earth fault check system.**

(30) Priority: **13.05.87 GB 8711280**

(43) Date of publication of application:
**17.11.88 Bulletin  88/46**

(45) Publication of the grant of the patent:
**16.09.92 Bulletin  92/38**

(84) Designated Contracting States:
**BE DE ES FR GB LU NL SE**

(56) References cited:
**GB-A- 506 665**
**GB-A- 758 551**
**GB-A- 929 008**
**US-A- 2 832 916**

(73) Proprietor: **INDUCTOTHERM EUROPE LIMITED**
**The Furlong**
**Droitwich WorcestershireWR9 9AH(GB)**

(72) Inventor: **Simcock, John Henry**
**9 Cockshute Hill**
**Droitwich Worcestershire(GB)**

(74) Representative: **Hands, Horace Geoffrey et al**
**LEWIS W. GOOLD & CO. Whitehall Chambers**
**23, Colmore Row**
**Birmingham B3 2BL(GB)**

## Description

This invention relates to earth fault check systems for the high voltage transformer secondary circuits of an induction furnace using d.c. injection to test for earth leakage.

GB-A-506665 describes one form of furnace earth fault check system in an induction furnace power supply circuit having an induction coil fed with high voltage current from an high voltage supply and a probe connecting the molten metal in the furnace crucible to earth. An earth leakage unit injects a D.C. feed into the circuit supplying the coil. A relay in said unit actuates circuit breakers to disconnect the said supply to the coil if leakage of the injected D.C. exceeds a predetermined level, and there is provision for resetting the earth leakage unit manually after it has tripped. This known system will respond only to leakage to earth in the furnace itself or in the immediate feed thereto and acts to isolate only the furnace induction coil.

The object of the invention is to provide an earth fault check system in a furnace power supply which operates effectively for safe and reliable protection for both equipment and operators by responding automatically to faults back to and including the high voltage source and whose response provides an indication of what part of the circuit has been affected by a fault as well as reliably isolating the affected parts of the circuit.

The invention provides a power supply circuit with the features specified in the preamble of claim 1 and characterised in that said high voltage supply includes an invertor supplied at its input side from the secondary windings of a transformer and connected at its output side to the induction coil; said means for automatically isolating the coil from the high voltage supply includes a control relay arranged to inhibit the operation of the invertor when the leakage of direct current exceeds said predetermined level; and said earth fault check system includes means controlling the operation of circuit breaker means placed in the feed to the transformer primary side, the earth fault check system being arranged to actuate said circuit breaker means for automatic isolation of the transformer when the earth leakage unit is successfully reset after operation of the control relay inhibiting operation of the invertor, i.e. while a fault exists on the input side of the invertor, whereby an indication is provided of whether the fault is on the input or output side of the invertor.

Further features of the invention will be better understood from the following description of an embodiment of the invention, applied to a metal melting induction furnace with reference to the accompanying drawings wherein:-

Figure 1 is a schematic diagram showing the furnace circuit layout; and

Figure 2 is a similarly schematic diagram of earth leakage unit connections thereof.

Referring to the drawings the furnace circuit includes a three phase high-voltage power supply 10 connected via an HV circuit breaker 12 controlled by an inverse definite minimum time relay (IDMT) 14 to the primary side 16 of an HV transformer 18, with an earth screen 20 interposed before the secondary windings 22. The latter are connected via moulded case circuit breakers (MCCB) 24 and fuses 26 to thyristor bridge rectifiers 28 which are connected to an invertor 30. The output from the invertor is connected to the heating coil 32 of the furnace crucible 34. The furnace heating coil circuits include a voltage sensitive relay 48 and an earth leakage unit (ELU) 36. The furnace crucible containing molten metal in use includes a probe 38 connecting the molten metal to earth.

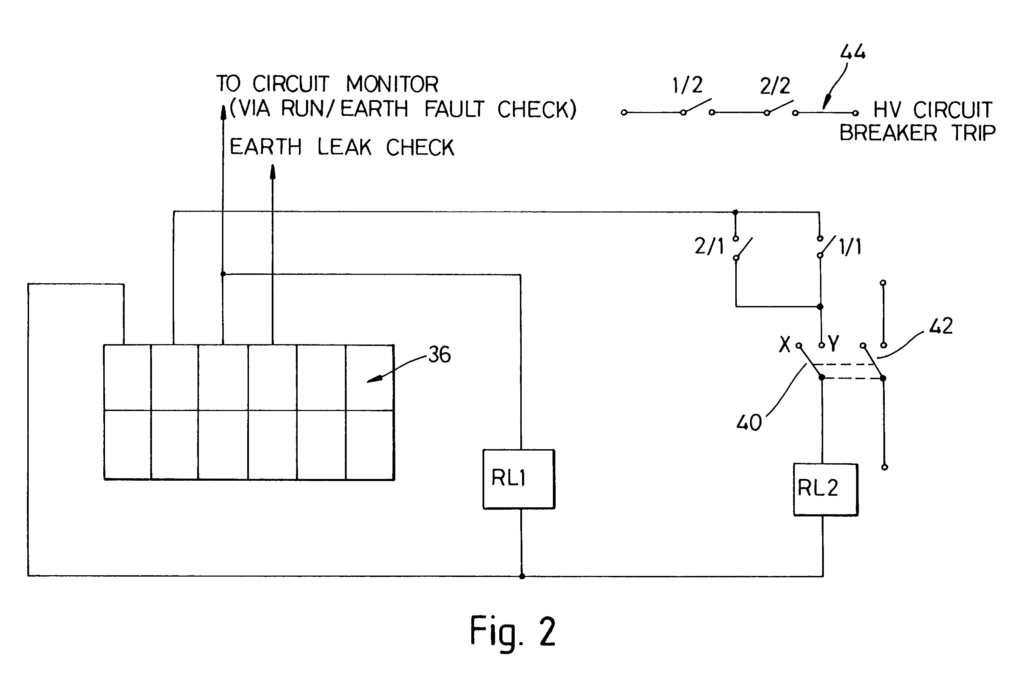

Earth leakage unit 36 is connected to two relays, RL1 and RL2 in Figure 2, and RL2 is connected via a start/reset switch 40 which is ganged with a second switch 42 operated when the furnace is to be run and an earth fault check initiated.

In operation, the invertor is started by operating the ganged run/earth fault check and start/reset switches 42,40. With these in position X when the ELU 36 is reset contacts 1/2 will be closed, and contacts 2/2 open in the HV circuit-breaker trip circuit 44. Switches 40,42 can then be operated to position Y and the invertor started. The earth leakage unit (ELU) 36 now monitors the complete melting circuit including the HV transformer secondaries 22, the feed cables, the invertor drive circuits, the furnace bus bars and for example water cooled flexible leads to the furnace coil 32.

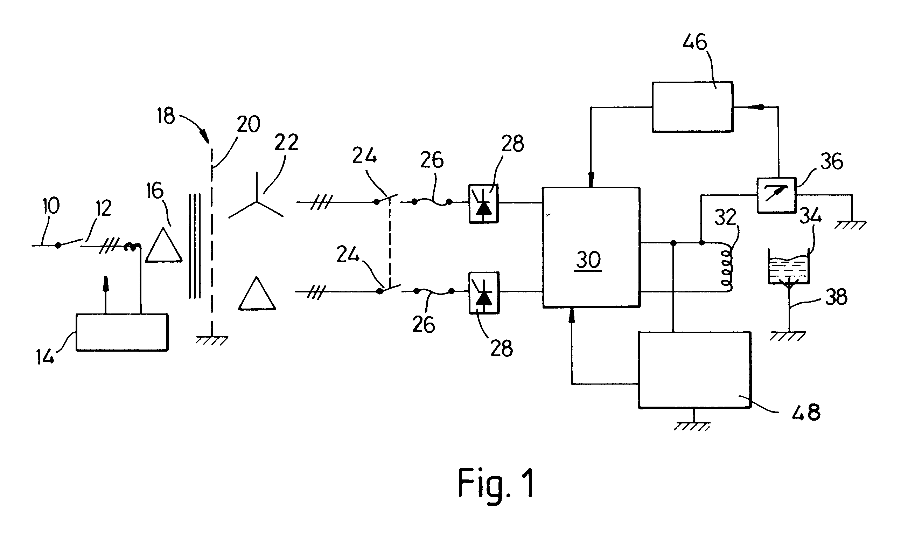

In the event of leakage of the D.C. current injected from unit 36 reaching the trip level which may be approximately 60 mA, RL1 will de-energise and RL2 will be latched. There may be an indicator lamp associated with ELU 36 which will light, and the invertor 30 is automatically isolated by operation of a control relay 46 (Fig.1). If the ELU reset switch 40 is operated and will not reset, it is because the earth fault is located in invertor 30 or beyond the invertor on the load side, that is to say in the furnace bus bars or furnace coil 32 for example.

However, if the ELU 36 can be reset (via its own reset button) successfully it will be because the earth fault is located on the supply side of invertor 30 and in this case the high voltage circuit breaker 12 and the MCCB's 24 will trip automatically.

The earth fault can now be safely investigated since the HV transformer 18 is isolated from invertor 30 and the furnace circuit so that they can be investigated separately.

The IDMT relay 14 protects against primary earth fault and primary current overload.

The DC injection current is preferably reversed in polarity periodically to eliminate electrolytic corrosion.

To summarise, as will be appreciated by those skilled in the art, this earth fault protection system provides automatic facilities for switching off the melting plant invertor 30 in the event of an earth fault occurring. It allows safe and systematic isolation of the fault in the major parts of the circuit. It uses a single DC injection system for checking the whole electrical circuit for leakage to ground. It ensures safe operation of the melting plant in conjunction with the normal HV supply transformer primary winding protection which uses correctly set IDMT relays 14. It provides automatic isolation of the HV transformer 18 at its primary circuit breaker and simultaneous isolation at the invertor MCCB's 24 (initiated by their under-voltage release trip) in the event of an HV transformer secondary winding and/or secondary cables or bus bars earth fault. These facilities, coupled with the earthed screen 20 between the primary and the secondary windings of the HV transformer 18 ensure maximum equipment and operator protection. A further protective feature is provided by the voltage sensitive relay 48 which will stop the invertor if the voltage at one side of the furnace coil 32 exceeds for example 600 V r.m.s. relative to ground. All of this enables the whole invertor melting circuit, including the HV transformer secondary windings 22, the transformer feed cables or bus bars to the invertor 30, the invertor circuitry, the furnace circuit bars and flexible connection and the furnace coil 32 itself to be operated floating from ground potential to enable the sensitive DC injection earth leakage check to be made. The ELU 36 is a fail-safe system with built-in self-check facilities ensuring its correct operation. A check is provided to ensure that the furnace probe 38, connecting the molten metal to earth, is always in contact with the molten metal.

## Claims

1. Power supply circuit for an induction furnace including an induction coil (32) fed with high voltage current from an high voltage supply, and an earth fault check system with an earth leakage unit (36) operating to inject direct current into the circuit feeding the coil and to actuate means for automatically isolating the coil from the high voltage supply if leakage of direct current exceeds a predetermined level, said earth leakage unit being provided with resetting means (40, 42); characterised in that

said high voltage supply includes an invertor (30) supplied at its input side from the secondary windings (22) of a transformer (18) and connected at its output side to the induction coil (32) ;

said means for automatically isolating the coil from the high voltage supply includes a control relay (46) arranged to inhibit the operation of the invertor (30) when the leakage of direct current exceeds said predetermined level; and said earth fault check system includes means (RL1, 1/1, 1/2, RL2, 2/1, 2/2,) controlling the operation of circuit breaker means (12) placed in the feed to the transformer primary side (16), the earth fault check system being arranged to actuate said circuit breaker means (12) for automatic isolation of the transformer (18) when the earth leakage unit is successfully reset after operation of the control relay (46) inhibiting operation of the invertor (30), i.e. while a fault exists on the input side of the invertor, whereby an indication is provided of whether the fault is on the input or output side of the invertor.

2. A circuit as in Claim 1 characterised in that the transformer (18) has an earth screen (20) between its primary and secondary sides (16,22).

3. A circuit as in Claim 1 or 2 characterised in that the circuit breaker means of the feed to the transformer primary side (16) includes an H.V. circuit breaker (12) controlled by an inverse definite minimum time relay (14)

4. A circuit as in Claim 1, 2 or 3 characterised in that it includes further circuit breaker means (24) between the output side of the transformer secondary windings (22) and the input side of the invertor (30).

5. A circuit as in Claim 4 characterised in that said further circuit breaker means include moulded case circuit breakers (24) connected between said secondary windings (22) and bridge rectifiers (28) feeding the invertor (30).

6. A circuit as in any preceding claim characterised in that it further includes a voltage sensitive relay (48) for automatically inhibiting operation of the invertor (30) if the voltage at one side of the furnace coil (32) exceeds a predetermined level relative to ground.

## Patentansprüche

1. Stromzuführschaltung für einen Induktionsofen, enthaltend eine Induktionsspule (32), die mit Hochspannungsstrom von einer Hochspannungszuleitung gespeist wird, und ein Erdfehlerüberwachungssystem mit einer Erdschlußeinheit (36) in einer Betriebsweise, daß Gleichstrom in die die Spule speisende Schaltung injiziert und eine Einrichtung zum automatischen Isolieren der Spule von der Hochspannungszuleitung betätigt wird, falls ein Leckverlust des Gleichstroms eine vorgegebene Höhe übersteigt, wobei die genannte Erdschlußeinheit mit einer Rückstelleinrichtung (40, 42) versehen ist,
dadurch gekennzeichnet, daß

- die genannte Hochspannungszuleitung einen Wechselrichter (30) enthält, der an seiner Eingangsseite von den Sekundärwicklungen (22) eines Transformators (18) gespeist wird und an seiner Ausgangsseite mit der Induktionsspule (32) verbunden ist;
- die genannte Einrichtung zum automatischen Isolieren der Spule von der Hochspannungszuleitung ein Steuerrelais (46) enthält, das angeordnet ist, um den Betrieb des Wechselrichters (30) zu sperren, wenn der Gleichstrom-Leckverlust die vorgegebene Höhe übersteigt;
- das Erdfehlerüberwachungssystem Einrichtungen (RL1, 1/1, 1/2, RL2, 2/1, 2/2) zur Steuerung des Betriebs einer Leistungsschaltereinrichtung (12) enthält, die in der Zuführung zur Transformator-Primärseite (16) angeordnet ist, wobei das Erdfehlerüberwachungssystem angeordnet ist, um die genannte Leistungsschaltereinrichtung (12) für eine automatische Isolation des Transformators (18) zu betätigen, wenn die Erdschlußeinheit erfolgreich zurückgestellt ist nach einem Betrieb des Steuerrelais (46) zum Sperren eines Betriebs des Wechselrichters (30), d.h. während ein Fehler an der Eingangsseite des Wechselrichters vorhanden ist, wodurch eine Anzeige geschaffen wird, ob der Fehler an der Eingangs- oder Ausgangsseite des Wechselrichters vorhanden ist.

2. Schaltung nach Anspruch 1, dadurch gekennzeichnet, daß der Transformator (18) eine Erdabschirmung (20) zwischen seinen primär- und Sekundärseiten (16, 22) aufweist.

3. Schaltung nach Anspruch 1 oder 2, dadurch gekennzeichnet, daß die Leistungsschaltereinrichtung der Zuführung zur Transformator-Primärseite (16) einen Hochspannungs-Leistungsschalter (12) enthält, der durch ein umgekehrt abgegrenztes Minimum-Zeitrelais (14) gesteuert wird.

4. Schaltung nach Anspruch 1, 2 oder 3, dadurch gekennzeichnet, daß sie ferner eine Leistungsschaltereinrichtung (24) zwischen der Eingangsseite der Transformator-Sekundärwicklungen (22) und der Eingangsseite des Wechselrichters (30) enthält.

5. Schaltung nach Anspruch 4, dadurch gekennzeichnet, daß die weitere Leistungsschaltereinrichtung einen Formgehäuse-Leistungsschalter (24) enthält, der zwischen den genannten Sekundärwicklungen (22) und Brückengleichrichtern (28) angeschlossen ist, die den Wechselrichter (30) speisen.

6. Schaltung nach einem der vorhergehenden Ansprüche, dadurch gekennzeichnet, daß sie ferner ein spannungsempfindliches Relais (48) enthält, zum automatischen Sperren eines Betriebs des Wechselrichters (30), falls die Spannung auf einer Seite der Ofenspule (32) eine vorbestimmte Höhe gegenüber Erde übersteigt.

**Revendications**

1. Circuit d'alimentation en énergie pour un four à induction comprenant une bobine d'induction (32) alimentée en courant à haute tension, à partir d'une alimentation à haute tension, et un système de surveillance des défauts de mise à la terre avec un ensemble de perte à la terre (36) qui agit pour injecter un courant continu dans le circuit alimentant la bobine et pour actionner un moyen isolant automatiquement la bobine de l'alimentation à haute tension si une perte de courant continu excède un niveau prédéterminé, ledit ensemble de perte à la terre comportant un moyen de remise en position (40,42), caractérisé en ce que :

ladite alimentation à haute tension comprend un inverseur(30) alimenté du côté de son entrée à partir des enroulements secondaires (22) d'un transformateur (18) et dont le côté de sortie est relié à la bobine d'induction (32) ;

ledit moyen isolant automatiquement la bobine de l'alimentation à haute tension comprend un relais de commande (46) conçu pour interdire le fonctionnement de l'inverseur (30) quand la perte de courant continu excède ledit niveau prédéterminé ; et

ledit système de surveillance des défauts de mise à la terre comprend un moyen (RL1, 1/1, 1/2, RL2, 2/1, 2/2) qui commande le fonctionnement d'un moyen d'interrupteur (12) placé dans l'alimentation du côté du primaire du transformateur (16), le système de surveillance des défauts de mise à la terre étant conçu pour actionner ledit moyen d'interrupteur (12) pour isoler automatiquement le transformateur (18) quand l'ensemble de perte à la terre est remis en position avec succès après un fonctionnement du relais de commande (46) interdisant le fonctionnement de l'inverseur (30, c'est-à-dire tandis qu'un défaut existe du côté de l'entrée de l'inverseur, de façon à fournir une indication sur la localisation du défaut du côté de l'entrée ou du côté de la sortie de l'inverseur.

2. Circuit selon la revendication 1, caractérisé en ce que le transformateur comporte un écran relié à la terre (20) disposé entre ses côtés du primaire et du secondaire (16,22).

3. Circuit selon la revendication 1 ou 2, caractérisé en ce que le moyen d'interrupteur de l'alimentation du côté du primaire (16) du transformateur comprend un interrupteur à haute tension (12) commandé par un relais inverseur à minimum de temps défini (14).

4. Circuit selon la revendication 1, 2 ou 3, caractérisé en ce qu'il comprend un moyen d'interrupteur supplémentaire (24) disposé entre le côté de sortie des enroulements secondaires (22) du transformateur et le côté d'entrée de l'inverseur (30).

5. Circuit selon la revendication 4, caractérisé en ce que ledit moyen d'interrupteur supplémentaire comprend des interrupteurs (24) à boîtier moulé qui sont reliés entre lesdits enroulements secondaires (22) et des redresseurs en pont (28) qui alimentent l'inverseur (30).

6. Circuit selon l'une quelconque des revendications précédentes, caractérisé en ce qu'il comprend de plus un relais sensible à la tension (48) pour interdire automatiquement le fonctionnement de l'inverseur (30) si la tension d'un côté de la bobine (32) du four dépasse un niveau prédéterminé par rapport à la terre.

Fig. 1

EP 0 291 156 B1

Fig. 2

TO CIRCUIT MONITOR
(VIA RUN/EARTH FAULT CHECK)

EARTH LEAK CHECK

1/2    2/2    44    HV CIRCUIT
BREAKER TRIP

2/1    1/1

X    Y    42

40

36

RL1    RL2

EP 0 291 156 B1